# EUROPEAN PATENT APPLICATION

(11) **EP 4 852 689 A1**
(43) Date of publication of application: **09.12.2026**
(21) Application number: 26182134.2
(22) Date of filing: 29.05.2026
(51) Int. Cl.: H10N 10/17, H10N 10/82, H10N 19/00

(54) **THERMOELECTRIC MODULE**

(30) Priority: 06.06.2025 GR 20250100417; 25.07.2025 GB 202512121
(71) Applicant: European Thermodynamics Limited, Leicester, Leicestershire LE8 0RX (GB)
(72) Inventor: KOZ, Cevriye, Kibworth, LE8 0RX (GB); LYDIARD, Richard, Kibworth, LE8 0RX (GB); TULEY, Richard, Kibworth, LE8 0RX (GB); STEFANAKI, Eleni-Chrysanthi, kibworth, LE8 0RX (GB)
(74) Representative: Barker Brettell LLP

(57) **Abstract**

A thermoelectric module comprising:
- a first sub-module and a second sub-module, wherein the first sub-module and the second sub-module each include:
o a first substrate with one or more first electrical interconnects provided thereon;
o a second substrate with one or more second electrical interconnects provided thereon; and
o two or more thermoelectric elements disposed between the first substrate and the second substrate,
wherein a first end of each thermoelectric element is electrically connected to one of the first electrical interconnects and a second end of each thermoelectric element is electrically connected to one of the second electrical interconnects, wherein at least two of the thermoelectric elements are electrically connected in series to form at least one thermocouple; and
a connector coupled to and extending between the first sub-module and the second sub-module, wherein the connector is flexible and/or stretchable at least in part to allow the relative positions of the first sub-module and the second sub-module to be varied, in use.

## Description

The present disclosure relates to a thermoelectric module.

Thermoelectric modules may be used as a heat pump for temperature control including cooling and heating or they may be used in power generation mode by utilising a heat flux to generate electrical power.

Standard thermoelectric modules are rigid devices. It can be challenging to enable thermal coupling of a thermoelectric module with more complex surfaces or surfaces that can change shape. This may require, for example, a flexible and stretchable thermoelectric module.

Hong et al., Sci. Adv. 2019;5: eaaw0536, Wearable thermoelectrics for personalized thermoregulation, discloses a flexible and stretchable thermoelectric cooler using a flexible and stretchable substrate.

Fukuie et al., Micromachines 2018, 9, 315; doi:10.3390/mi9070315, Design of Substrate Stretchability Using Origami-Like Folding Deformation for Flexible Thermoelectric Generator, discloses a flexible and stretchable thermoelectric generator. This uses a bendable but non-stretchable substrate. The stretchability is realized by connecting each rigid thermoelectric element with folded wiring parts.

Sato et al., Micromachines 2023, 14, 218., Origami-Type Flexible Thermoelectric Generator Fabricated by Self-Folding, discloses a thermoelectric generator with an origami structure that enables both flexibility and the usage of high-performance rigid materials by self-folding between thermoelectric elements.

Fan et al., Adv. Sci. 2023, 10, 2206397, High-Performance Stretchable Thermoelectric Generator for Self-Powered Wearable Electronics discloses a flexible thermoelectric generator using thermoelectric units each connected by a stretchable Cu electrode.

A first aspect provides a thermoelectric module comprising:
- a first sub-module and a second sub-module, wherein the first sub-module and the second sub-module each include:
   o a first substrate with one or more first electrical interconnects provided thereon;
   o a second substrate with one or more second electrical interconnects provided thereon; and
   o two or more thermoelectric elements disposed between the first substrate and the second substrate,
      wherein a first end of each thermoelectric element is electrically connected to one of the first electrical interconnects and a second end of each thermoelectric element is electrically connected to one of the second electrical interconnects, wherein at least two of the thermoelectric elements are electrically connected in series to form at least one thermocouple; and
- a connector coupled to and extending between the first sub-module and the second sub-module, wherein the connector is flexible and/or stretchable at least in part to allow the relative positions of the first sub-module and the second sub-module to be varied, in use.

In implementations, the thermoelectric module may include one or more further sub-modules. Each sub-module may be connected to at least one other sub-module by one or more connectors. The connector(s) may each be coupled to and extend between a first one of the sub-modules and a second one of the sub-modules, wherein one or more of the connectors, e.g. each connector, may be flexible and/or stretchable at least in part to allow the relative positions of the first one of the sub-modules and the second one of the sub-modules to be varied, in use.

In implementations, one or more of the connectors may be electrically conductive. The connector may provide an electrical connection between the first sub-module and the second sub-module.

In implementations, one or more of the connectors may comprise one or more, e.g. a plurality of, connector strands. One or more of the connectors may comprise a first connector strand and a second connector strand.

In a given connector, each connector strand may be independently coupled to and extend between a first one of the sub-modules and a second one of the sub-modules.

Thermoelectric elements typically have a low electrical resistance. Existing high performance thermoelectric elements used in thermoelectric modules are rigid or have low flexibility. The present inventors have identified that it would be beneficial to utilise existing high performance thermoelectric elements whilst adding a degree of flexibility to the thermoelectric module.

One approach to make a flexible and stretchable thermoelectric module is to utilise flexible and stretchable connectors between the more rigid thermoelectric elements. However, it is challenging to design sufficiently flexible connectors between the more rigid thermoelectric elements that can carry current with sufficiently low electrical resistance to avoid having a significant reduction in thermoelectric performance as a thermoelectric generator or thermoelectric cooler. The present inventors have identified two simultaneous approaches to reduce the impact of the electrical resistance of the connector.

First, the use of sub-modules including at least two thermoelectric elements between each connector. This may increase the resistance of the thermoelectric module by at least two compared to the connector, reducing the relative performance loss due to the electrical resistance of the connector.

Secondly, the flexible and/or stretchable connector may comprise a first connector strand and a second connector strand between the sub-modules, which may be configured to connect electrically the sub-modules in parallel. This may reduce the total resistance of the electrical connection between sub-modules by at least two, further reducing the performance loss due to the electrical resistance of the connector. This may have an additional non-obvious benefit of increasing the resilience of the thermoelectric module or a thermoelectric device including the thermoelectric module, as the thermoelectric device may continue to function even with the failure of one of the connector strands. Multiple connector strands typically also may have an increased flexibility or higher force at failure compared to a single connector strand with a higher cross-sectional area, due to non-linear effects on thickness and stress concentrations that occur at the edges of the connector strands under bending.

These approaches can complement each other as the larger area taken up by a sub-module compared to a single thermoelectric element may allow additional lateral space to fit in multiple flexible connectors. This can be performed without reducing the fraction of area that can be filled with thermoelectric material, so as to avoid reducing the heat flow that can be pumped as a thermoelectric cooler or the power produced at a fixed temperature differences as a thermoelectric generator.

Within the thermoelectric module or one or more of the sub-modules, n-type and p-type thermoelectric elements may be electrically connected in series in at least one series-connected string comprising alternating n-type and p-type thermoelectric elements. An n-type thermoelectric element and a p-type thermoelectric element electrically connected in series may be considered to make up a thermocouple.

The connector is flexible and/or stretchable. In implementations, the connector or a part thereof, e.g. the or a first connector strand and/or the or a second connector strand, may be deformable from a neutral (i.e. unstressed) position or arrangement. The neutral position may be a resting position of the connector or a part thereof, e.g. a resting position of the first connector strand and/or a resting position of the second connector strand, e.g. when no external forces are applied to the connector or a part thereof. The deformable nature of the flexible and/or stretchable connector enables the thermoelectric module to be distorted.

Within the thermoelectric module, it may be advantageous to form at least partially one or more of the connectors from one or more materials with high electrical conductivity such as a metal, but to form the connector(s) in such a way as to allow geometric distortion to create a stretchable and/or flexible connector. Forming the connector(s) or parts thereof in a shape that can increase its length by local bending and/or out of plane distortion, such as the non-linear geometries discussed herein, may allow, for example, significantly higher stretchability of a structure compared to the properties of a rod of equivalent material. Suitable metals for the connector(s) or parts thereof may include but are not limited to copper, silver, gold, nickel, aluminium, platinum, tin, lead, carbon or combinations or multiple layers of the above.

The connector is flexible and/or stretchable at least in part. For example, less than half, half of, more than half of, or substantially all of the connector may be flexible and/or stretchable.

In implementations, the connector(s) or a part thereof, e.g. a connector strand such as the or a first connector strand and/or the or a second connector strand may be resiliently biased to the or a neutral position. As such, for example, the connector may be compressible, stretchable or bendable upon application of an urging force thereto but may return to the neutral position upon removal of the force.

In implementations, the connector may include three or more connector strands. Each connector strand may be independently coupled to and extend between the first sub-module and the second sub-module. In implementations, each connector strand may be independently coupled to and extend between one of the electrical interconnects of the first sub-module and one of the electrical interconnects of the second sub-module. The use of multiple connector strands may provide increased flexibility relative to a single strand, especially where the sum of the widths of the individual strands is not more than the width of a single strand.

In implementations, in one or more of the connectors, two or more, such as three or more, or four or more, of the connector strands may adopt a mirroring geometry. The connector strands may therefore be symmetrical about a plane extending perpendicularly, such as substantially vertically, through each sub-module, e.g. through the centre of each sub-module. This may enable multiple sub-modules to be efficiently coupled together.

In implementations, two or more, such as three or more, or four or more of the connector strands of the connector may adopt a non-linear geometry. By forming a non-linear geometry, such as a shape that can increase its length by local bending and/or out of plane distortion may provide for significantly higher stretchability of a structure compared, for example, to the properties of a rod of equivalent material.

In implementations, the non-linear geometry may include a curved or a sinusoidal geometry, wherein the connector strand(s) may adopt at least in part a serpentine shape, e.g. comprising a series of hairpin bends with adjoining sections between each adjacent bend. In implementations, the non-linear geometry may include a castellated geometry. In implementations, the non-linear geometry may include a ridged geometry. In implementations, the non-linear geometry may include an arc geometry. In implementations, the non-linear geometry may include a helical geometry. In implementations, the geometry may meander such that the length along the connector strand is longer than the shortest straight-line distance between the sub-modules. This may allow the connector to stretch and/or compress by geometric distortion.

In implementations, the non-linear geometry may include an arced geometry, wherein a centreline radius of one or more of the arcs may be 0.1 mm or greater, such as 0.5 mm or greater, 1 mm or greater, 2 mm or greater, 3 mm or greater, 4 mm or greater, 5 mm or greater, 6 mm or greater, 7 mm or greater, 8 mm or greater, or 9 mm or greater.

In implementations, the non-linear geometry may include an arced geometry, wherein a centreline radius of one or more of the arcs may be 10 mm or less, such as 9 mm or less, 8 mm or less, 7 mm or less, 6 mm or less, 5 mm or less, 4 mm or less, 3 mm or less, 2 mm or less, or 1 mm or less.

In implementations, the non-linear geometry may include an arced geometry, wherein a centreline radius of one or more of the arcs may be from 0.1 mm to 10 mm, such as from 0.5 mm to 9 mm, or from 1 mm to 8 mm.

In implementations, the non-linear geometry may include an arced geometry, wherein a centreline radius of one or more the arcs may be in the range of 0.1 mm to 10 mm. A balance in the size of the radius of the arc(s) may be important, as too small a radius can reduce the extension of the connector before failure, and can reduce the failure force, but too high a radius may take up too much space, reducing the area available for the sub-modules with the thermoelectric elements.

In implementations, the non-linear geometry may include an arced geometry, wherein an angular extent of one or more of the arcs may be 150° or greater, such as 180° or greater, 210° or greater, or 240° or greater.

In implementations, the non-linear geometry may include an arced geometry, wherein an angular extent of one or more of the arcs may be 270° or less, such as 240° or less, 210° or less, or 180° or less.

In implementations, the non-linear geometry may include an arced geometry, wherein an angular extent of one or more of the arcs may be in the range of from 150° to 270°, such as from 180° to 240°.

In implementations, the non-linear geometry may include an arced geometry, wherein an angular extent of one or more of the arcs may be in the range of from 150° to 270°. It may be advantageous to make the connector or a connector strand out of one or more arcs to reduce any local stress concentrations, which increases the elongation and maximum force at failure.

In implementations, two or more of the connector strands may be nested. The two or more nested connector strands may abut each other at one or more points along their respective lengths. Increasing the number of connector strands nested together may increase redundancy and/or decrease the electrical resistance of the connectors, reducing the performance loss from the connector.

In implementations, the first connector strand and the second connector strand may be nested together, to provide a first pair of nested connector strands. In implementations, more than two connector strands may be nested together. The first connector strand and the second connector strand may abut each other at one or more points along their respective lengths.

In implementations, the thermoelectric module may include a third connector strand and, optionally, a fourth connector fourth strand, independently coupled to and extending between the first sub-module and the second sub-module. Each connector strand may be independently coupled to and extend between one of the electrical interconnects of the first sub-module and one of the electrical interconnects of the second sub-module.

In implementations, the third connector strand and the fourth strand may be nested together, to provide a second pair of nested connector strands. The third connector strand and the fourth connector strand may abut each other at one or more points along their respective lengths.

In implementations, the or a first set, e.g. the or a first pair, of nested connector strands and the or a second set, e.g. the or a second pair, of nested connector strands may adopt a mirroring geometry. The or a first set of nested connector strands and the or a second set of nested connector strands may therefore be symmetrical about a plane extending perpendicularly, such as substantially vertically, through each sub-module, e.g. through the centre of each sub-module. This may enable multiple sub-modules to be efficiently coupled together.

In implementations, one or more of the connector strands may be configured to carry electrical current from the first sub-module to the second sub-module.

In implementations, the connector and/or one or more of the connector strands may constitute an extension of one of the substrates and/or one of the electrical interconnects of the first sub-module and/or the second sub-module. For instance, the connector any/or one or more of the connector strands may constitute an extension of the first substrate and/or one of the first electrical interconnects of the first sub-module and/or the second sub-module and/or an extension of the second substrate and/or one of the second electrical interconnects of the first sub-module and/or the second sub-module. This may simplify manufacturing, as the connector(s) and one or more of the substrates and/or one or more of the electrical interconnects can be formed in one step, requiring no additional assembly operation to bond them together that may also affect their flexibility.

In implementations, each sub-module may comprise at least one outer layer disposed on an outer face of the first substrate or an outer face of the second substrate. This additional outer layer can add stiffness to the sub-modules, helping to protect the thermoelectric elements by distributing any applied stresses more evenly across the sub-module and making assembly easier. This may be especially advantageous when using flexible substrates.

In implementations, each sub-module may comprise an outer layer disposed on the outer face of the first substrate and an outer layer disposed on an outer face of the second substrate. This additional outer layer can add stiffness to the sub-modules, helping to protect the thermoelectric elements by distributing any applied stresses more evenly across the sub-module and making assembly easier. This may be especially advantageous when using flexible substrates.

In implementations, one or more of the connector strands may be independently coupled to one of the electrical interconnects of the first sub-module and one of the electrical interconnects of the second sub-module. Such connection may allow the sub-modules to be electrically connected in series.

In implementations, one or more of the connector strands may be independently coupled to one of the first electrical interconnects of the first sub-module and one of the first electrical interconnects of the second sub-module. Such connection may allow the sub-modules to be electrically connected in series.

In implementations, one or more of the connector strands may be independently coupled to one of the second electrical interconnects of the first sub-module and one of the second electrical interconnects of the second sub-module. Such connection may allow the sub-modules to be electrically connected in series.

In the case where one or more of the connector strands is independently coupled to one of the first electrical interconnects of the first sub-module and one of the first electrical interconnects of the second sub-module, and another connector strand is independently coupled to one of the first electrical interconnects of the first sub-module and one of the first electrical interconnects of the second sub-module, the sub-modules may be electrically connected in parallel.

In the case where one or more of the connector strands is independently coupled to one of the second electrical interconnects of the first sub-module and one of the second electrical interconnects of the second sub-module, and another connector strand is independently coupled to one of the second electrical interconnects of the first sub-module and one of the second electrical interconnects of the second sub-module, the sub-modules may be electrically connected in parallel.

In implementations, one or more of the connector strands may be independently coupled to one of the first electrical interconnects of the first sub-module and one of the second electrical interconnects of the second sub-module, or one or more of the connector strands may be independently coupled to one of the second electrical interconnects of the first sub-module and one of the first electrical interconnects of the second sub-module. Such connection may allow the sub-modules to be electrically connected in series.

In implementations, the thermoelectric module may comprise three or more sub-modules, such as four or more, five or more, six or more, seven or more, eight or more, nine or more, or ten or more sub-modules, wherein a connector is coupled to and extends between any two adjacent sub-modules to provide a string or an array, wherein one or more of the connectors is/are flexible and/or stretchable at least in part. A connector according to the present disclosure may be coupled to and extend between any two adjacent sub-modules. As such, there may be provided a string of more than two sub-modules. Alternatively or additionally, each sub-module of the two or more sub-modules may be provided as an array of more than two-sub-modules, such as 2 by 2 sub-modules, 2 by 4 sub-modules, or 4 by 4 sub-modules. Electrical wires or similar electrical contact to the thermoelectric module may be made at one end of the string or both ends of the string.

In implementations, the thermoelectric module may comprise up to four sub-modules, up to eight sub-modules, up to 16 sub-modules, up to 32 sub-modules, up to 64 sub-modules, up to 128 sub-modules or up to 256 sub-modules.

In implementations, one or more of the connectors may comprise a connector substrate and, optionally, a connector electrical interconnect. The connector electrical interconnect may be disposed on the connector substrate.

In implementations, one or more of the first electrical interconnects, one or more of the second electrical interconnects, and/or optionally one or more of the connector electrical interconnects may be covered at least partially by an insulating layer.

In implementations, one or more of the connector strands may comprise a connector strand substrate and, optionally, a connector strand electrical interconnect. The connector strand electrical interconnect may be disposed on the connector strand substrate.

In implementations, one or more of the connectors may be electrically inactive.

In implementations, one or more of the connector strands may be electrically inactive.

In implementations, one or more of the sub-modules may include up to four, up to eight, up to 16, up to 32, up to 64 or up to 128 thermoelectric elements.

One or more, e.g. two, electrical connectors, e.g. wires or the like, may be configured to provide external electrical connection to the thermoelectric module.

A second aspect provides a sub-unit for a thermoelectric module including:
a sub-module including:
   a first substrate with one or more first electrical interconnects provided thereon;
   a second substrate with one or more second electrical interconnects provided thereon;
   two or more thermoelectric elements disposed between the first substrate and the second substrate, wherein a first end of each thermoelectric elements is electrically connected to one of the first electrical interconnects and a second end of each thermoelectric element is electrically connected to one of the second electrical interconnects, wherein two or more of the thermoelectric elements are electrically connected in series to form at least one thermocouple; and
a connector coupled to and extending from the sub-module to be connect the sub-module, in use, to another sub-module, wherein the connector is flexible and/or stretchable at least in part to allow the relative positions of the sub-module and the another sub-module to be varied, in use.

The above-mentioned benefits relating to the thermoelectric module similarly may apply to the sub-unit of the second aspect. A thermoelectric module may comprise one or more sub-units of the second aspect.

A third aspect provides a thermoelectric device comprising one or more thermoelectric modules and/or one or more sub-units and/or one or more sub-modules of present disclosure. The above-mentioned benefits relating to the thermoelectric module similarly may apply to the thermoelectric device. The flexibility of the thermoelectric module may enable the thermoelectric module(s) to be used in a wide variety of thermoelectric devices having a range of different applications.

The thermoelectric device may include a thermoelectric generator, a thermoelectric cooler or a thermoelectric heater.

A fourth aspect provides a method of manufacturing a thermoelectric module comprising:
providing a first sub-module and a second sub-module, wherein the first sub-module and the second sub-module each comprise:
   a first substrate with one or more first electrical interconnects provided thereon;
   a second substrate with one or more second electrical interconnects provided thereon; and
   two or more thermoelectric elements disposed between the first substrate and the second substrate, wherein a first end of each thermoelectric element is electrically connected to one of the first electrical interconnects and a second end of each thermoelectric element is electrically connected to one of the second electrical interconnects, wherein two or more of the thermoelectric elements are electrically connected in series to form at least one thermocouple;
coupling a connector to the first sub-module and the second sub-module such that the connector extends between the first sub-module and the second sub-module, wherein the connector is flexible and/or stretchable at least in part to allow the relative positions of the first sub-module and the second sub-module to be varied, in use.

Coupling a connector to the first sub-module and the second sub-module may include forming a connector between the first sub-module and the second sub-module.

Forming a connector between the first sub-module and the second sub-module may include extending one of the substrates and/or one of the electrical interconnects of the first sub-module and/or the second sub-module between the first sub-module and the second-sub-module.

The above-mentioned benefits associated with the thermoelectric module similarly may apply to the method of the fourth aspect.

In implementations, the method of manufacturing a thermoelectric module may further comprise a preliminary step of manufacturing or assembling the first sub-module and/or the second sub-module.

A fifth aspect provides a method of manufacturing a thermoelectric device comprising:
providing at least one thermoelectric module according to the present disclosure or a thermoelectric module manufactured according to a method of manufacture according to the present disclosure; and
configuring the thermoelectric module(s) for use in the thermoelectric device.

The person skilled in the art will appreciate that except where mutually exclusive, a feature described in relation to any one of the above aspects may be applied *mutatis mutandis* to any other aspect. Furthermore, except where mutually exclusive any feature described herein may be applied to any aspect and/or combined with any other feature described herein.

Implementations will now be described by way of example with reference to the accompanying drawings, in which:
**Figure 1****:** plan top view of a thermoelectric module.
**Figure 2****:** a cross-sectional view of a sub-module within the thermoelectric module of Figure 1.
**Figure 3****:** cross-sectional view of the thermoelectric module of Figure 1.
**Figure 4****:** cross-sectional view of the thermoelectric module of Figure 1.
**Figure 5****:** cross-sectional view of another example of a thermoelectric module.
**Figure 6****:** cross-sectional view of another example of a thermoelectric module.
**Figure 7****:** cross-sectional view of another example of a thermoelectric module.
**Figure 8****:** cross-sectional view of another example of a thermoelectric module.
**Figure 9****:** cross-sectional view of another example of a thermoelectric module.
**Figure 10****:** cross-sectional view of another example of a thermoelectric module.
**Figure 11****:** cross-sectional view of another example of a thermoelectric module.
**Figure 12****:** cross-sectional view of another example of a thermoelectric module.
**Figure 13****:** plan top view of another example of a thermoelectric module.
**Figure 14****:** cross-sectional view of a sub-module within the thermoelectric module of Figure 13.
**Figure 15****:** plan top view of another example of a thermoelectric module.
**Figure 16****:** cross-sectional view of a sub-module within the thermoelectric module of Figure 15.
**Figure 17****:** cross-sectional view of the thermoelectric module of Figure 15.
**Figure 18****:** cross-sectional view of the thermoelectric module of Figure 15.
**Figure 19****:** cross-sectional view of an example of a sub-module for a thermoelectric module.
**Figure 20****:** cross-sectional view of the sub-module of Figure 19.
**Figure 21****:** cross-sectional view of another example of a sub-module for a thermoelectric module.
**Figure 22****:** cross-sectional view of the sub-module of Figure 21.
**Figure 23****:** plan top view of another example of a thermoelectric module.
**Figure 24****:** plan top view of another example of a thermoelectric module.
**Figure 25****:** schematic diagram of a method of manufacturing a thermoelectric module.

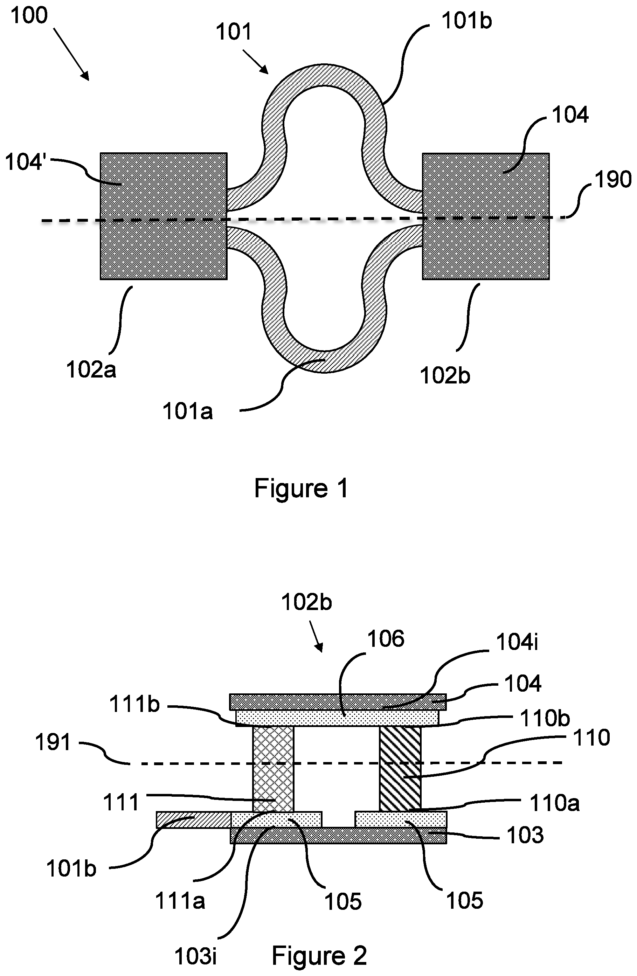

An example of a thermoelectric module 100 is shown in Figures 1 to 4.

A plan view of the thermoelectric module 100 is shown in Figure 1. The thermoelectric module 100 includes a first sub-module 102a and a second sub-module 102b.

Figure 2 is a cross-sectional view of the second sub-module 102b viewed from a first plane indicated by the first dashed line 190 in Figure 1.

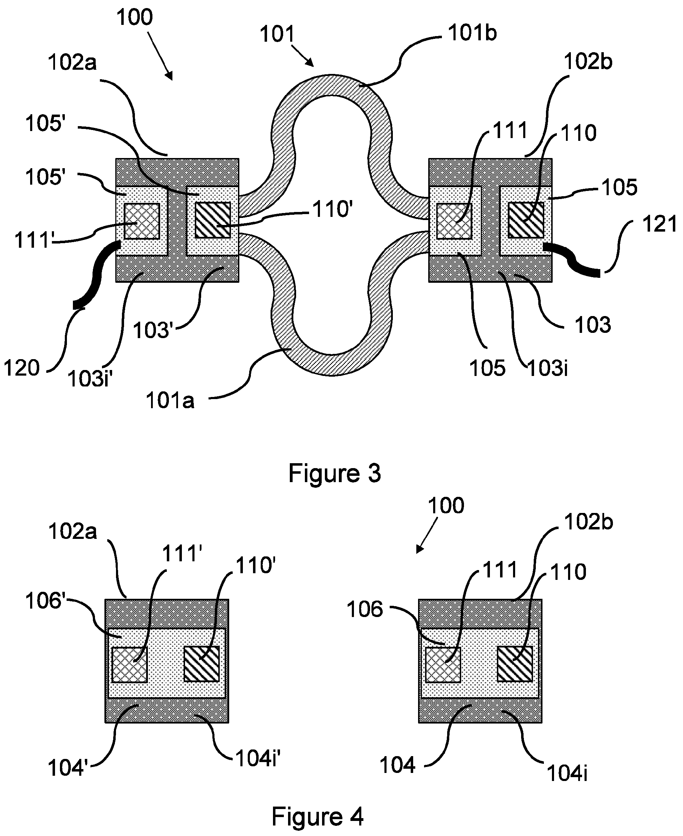

Figure 3 is a cross-sectional view of the thermoelectric module 100 viewed in a direction towards a first substrate 103' of the first sub-module 102a and a first substrate 103 of the second sub-module 102b from a second plane indicated by the second dashed line 191 in Figure 2.

Figure 4 is a cross-sectional view of the thermoelectric module 100 viewed in a direction towards a second substrate 104' of the first sub-module 102a and a second substrate 104 of the second sub-module 102b from the second plane indicated by the second dashed line 191 in Figure 2.

The first sub-module 102a may have a similar structure to the second sub-module 102b. In Figures 1-4 like reference numerals are used for corresponding features in the first sub-module 102a with the addition of a prime (').

A connector 101 extends from the first sub-module 102a to the second sub-module 102b. The connector 101 connects the first sub-module 102a to the second sub-module 102b. The connector 101 is flexible and stretchable to allow the relative positions of the first sub-module 102a and the second sub-module 102b to be varied, in use. For instance, a spacing between the first sub-module 102a and the second sub-module 102b may be varied. Additionally or alternatively, an orientation of the first sub-module 102a relative to the second sub-module 102b may be varied.

The connector 101 includes a first connector strand 101a and a second connector strand 101b. The first connector strand 101a the second connector strand 101b each have a generally sinusoidal form and have a mirroring geometry either side of the first plane indicated by the first dashed line 190.

The second sub-module 102b includes a first substrate 103 with two first electrical interconnects 105 provided thereon. A second substrate 104 has a second electrical interconnect 106 provided thereon. The two first electrical interconnects 105 are disposed on an inner surface 103i of the first substrate 103. The second electrical interconnect 106 is disposed on an inner surface 104i of the second substrate 104.

A first thermoelectric element 111 and a second thermoelectric element 110 are disposed between the first substrate 103 and the second substrate 104.

A first end 111a of the first thermoelectric element 111 is electrically connected to a first one of the first electrical interconnects 105. A second end 111b of the first thermoelectric element 111 is electrically connected to the second electrical interconnect 106.

A first end 110a of the second thermoelectric element 110 is electrically connected to a second one of the first electrical interconnects 105. A second end 110b of the second thermoelectric element 110 is electrically connected to the second electrical interconnect 106.

The first thermoelectric element 111 may be an n-type thermoelectric element and the second thermoelectric element 110 may be a p-type thermoelectric element or vice versa. Either way, the second sub-module 102b includes a thermocouple, i.e. an n-type thermoelectric element and a p-type thermoelectric element electrically connected in series.

The first connector strand 101a and the second connector strand 101b extend from a second one of the first electrical interconnects 105' in the first sub-module 102a to the first one of the first electrical interconnects 105 in the second sub-module 102b.

A first electrical wire 120 electrically connected to a first one of the first electrical interconnects 105' of the first sub-module 102a and a second electrical wire 121 electrically connected to a second one of the first electrical interconnects 105 of the second sub-module 102b may allow external electrical connection to the thermoelectric module 100.

The second sub-module 102b is electrically connected to the first sub-module 102a. The thermoelectric module 100 includes a series-connected string of thermoelectric elements 111', 110', 111, 110 across the first sub-module 102a and the second sub-module 102b.

In implementations, the connector 101 may be configured to carry electrical current, in order to provide an electrical connection from the first sub-module 102a to the second sub-module 102b. For instance, one or more of the first connector strand 101a and the second connector strand 101b may be electrically conductive.

For a low electrical resistance of the connector 101, it may be beneficial to form the connector 101 or a part thereof, e.g. one or more of the first and/or second connector strands 102a, 102b, from one or more materials with high electrical conductivity such as a metal.

Such materials may have intrinsically low stretchability (i.e. low elongation at tensile failure when formed as a rod). Therefore, it may be beneficial to use these materials but to form the connector or a part thereof in such a way as to allow geometric distortion to create a stretchable and/or flexible connector. By forming a shape that may be able to significantly vary, e.g. increase, its length by local bending and/or out of plane distortion, such as the arced meander geometry of the connector strands 101a, 102b of the connector 101 in Figures 1-4, significantly higher stretchability of a connector may be realised compared to the properties of a rod of equivalent material(s). Suitable metals for the connector and/or one or more parts thereof may include but are not limited to copper, silver, gold, nickel, aluminium, platinum, tin, lead, carbon or combinations or multiple layers of the above.

Suitable thermoelectric materials for the thermoelectric elements may include but are not limited to: bismuth telluride; bismuth selenide; antimony telluride; lead telluride; lead selenide; magnesium silicide; magnesium stannide; higher manganese silicide; magnesium antimonide; magnesium bismuthide; skutterudite materials; Half Heusler alloys; silicon-germanium, oxides and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

The first substrates 103, 103' and/or the second substrates 104, 104' may be made of a suitable material that is an electrical insulator. One or more of the first substrates 103, 103' and/or the second substrates 104, 104' may be rigid. For example, one or more of the first substrates 103, 103' and/or the second substrates 104, 104' may comprise aluminium oxide, aluminium nitride, silicon nitride or beryllium oxide.

In implementations, one or more of the first substrates 103, 103' and/or the second substrates 104, 104' may be flexible at least in part, e.g. one or more of the first substrates 103, 103' and/or the second substrates 104, 104' may be made at least partially of at least one flexible material. In implementations, one or more of the first substrates 103, 103' and/or the second substrates 104, 104' and/or the flexible material(s) may have a relatively low Young's modulus, e.g. up to 20 GPa. This may help to avoid stress concentrations within a thermoelectric module and/or to make at least part of the thermoelectric module and/or a thermoelectric device including the thermoelectric module more flexible.

Suitable materials for one or more of the first substrates 103, 103' and/or the second substrates 104, 104' may include but are not limited to polyimide, polyethylene terephthalate (PET), polyetheretherketone (PEEK), poly methyl methacrylate (PMMA), polystyrene, or cyclic olefin copolymer (COC).

Suitable materials for the electrical interconnects may include but are not limited to metals such as copper, silver, gold, nickel, aluminium, platinum, tin, lead or combinations or multiple layers of the above.

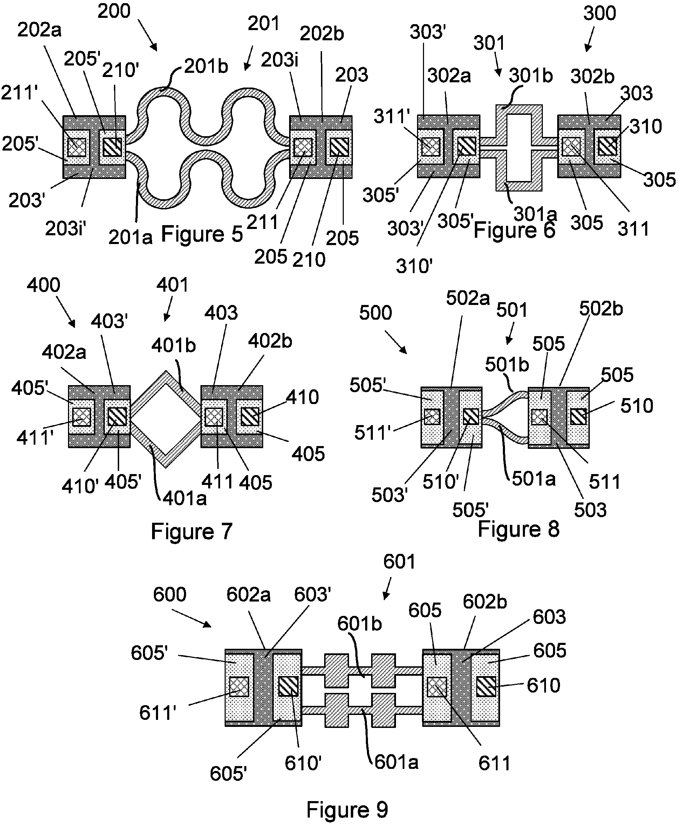

Figure 5 shows a cross-sectional view of another example of a thermoelectric module 200. The view is an equivalent view to that of Figure 3. As compared with the thermoelectric module 100, like reference numerals are utilised to indicate equivalent features of the thermoelectric module 200, except that the reference numerals start with a "2" instead of a "1".

The thermoelectric module 200 is substantially the same as the thermoelectric module 100, except that the first connector strand 201a and the second connector strand 201b have a different configuration. Each of the first connector strand 201a and the second connector strand 201b have a meandering sinusoidal geometry including three linked 180° curves.

Figure 6 shows a cross-sectional view of another example of a thermoelectric module 300. The view is an equivalent view to that of Figure 3. As compared with the thermoelectric module 100, like reference numerals are utilised to indicate equivalent features of the thermoelectric module 300, except that the reference numerals start with a "3" instead of a "1".

The thermoelectric module 300 is substantially the same as the thermoelectric module 100, except that the first connector strand 301a and the second connector strand 301b have a different configuration. Each of the first connector strand 301a and the second connector strand 301b have a meandering castellated geometry including series of square corners.

Figure 7 shows a cross-sectional view of another example of a thermoelectric module 400. The view is an equivalent view to that of Figure 3. As compared with the thermoelectric module 100, like reference numerals are utilised to indicate equivalent features of the thermoelectric module 400, except that the reference numerals start with a "4" instead of a "1".

The thermoelectric module 400 is substantially the same as the thermoelectric module 100, except that the first connector strand 401a and the second connector strand 401b have a different configuration. Each of the first connector strand 401a and the second connector strand 401b have a ridged geometry including a square corner at a midpoint thereof.

Figure 8 shows a cross-sectional view of another example of a thermoelectric module 500. The view is an equivalent view to that of Figure 3. As compared with the thermoelectric module 100, like reference numerals are utilised to indicate equivalent features of the thermoelectric module 500, except that the reference numerals start with a "5" instead of a "1".

The thermoelectric module 500 is substantially the same as the thermoelectric module 100, except that: the first electrical interconnects 505', 505 are rectangular and hence relatively elongate compared with the thermoelectric elements 511', 510', 511, 510; and the first connector strand 501a and the second connector strand 501b have a different configuration. The first connector strand 501a and the second connector strand 501b have a mirroring geometry. A first end of the first connector strand 501a and a first end of the second connector strand 501b are connected to the second one of the first electrical interconnects 505' of the first sub-module 502a. A second end of the first connector strand 501a and a second end of the second connector strand 501b are connected to the first one of the first electrical interconnects 505 of the second sub-module 502b. The first connector strand 501a and the second connector strand 501b each include a first curve having a first sign and a second curve having a second sign, the second sign having the same magnitude as and being opposite (i.e. negative or positive) to the first sign. The first ends of the first connector strand 501a and the second connector strand 501b are relatively closely spaced from each other, while the second ends of the first connector strand 501a and the second connector strand 501b are spaced relatively further apart from each other. The first connector strand 501a and the second connector strand 501b may be considered have a diverging geometry, i.e. they are space further apart from each other at their second ends than at their first ends and/or they get generally further apart from each other along their length.

In many implementations, e.g. as shown in Figures 1 to 8, the length along the connector strand(s) is longer than a shortest straight-line distance between the sub-modules. This may allow the connector to stretch and/or compress by geometric distortion.

Figure 9 shows a cross-sectional view of another example of a thermoelectric module 600. The view is an equivalent view to that of Figure 3. As compared with the thermoelectric module 500, like reference numerals are utilised to indicate equivalent features of the thermoelectric module 600, except that the reference numerals start with a "6" instead of a "5".

The thermoelectric module 600 is substantially the same as the thermoelectric module 500, except that the first connector strand 601a and the second connector strand 601b have a different configuration.

The thermoelectric module 600 includes an example of a connector 601 including a first connector strand 601a and a second connector strand 601b that is configured to rely on out of plane bending to change shape. To achieve stretchability, some mountain folds and valley folds out of the plane of the page are first applied to create a neutral position, achieving a shape that can stretch and compress. One or more regions of one or more of the connector strands 601a, 601b may be narrower, thinner and/or have special features to promote local folding. An advantage of this approach is that a more compact connector can be formed.

A benefit of the use of non-linear designs for the connector and/or connector strand(s), e.g. as shown in Figures 1 to 8, can be that any radius of curvature of bending applied to the connector and/or the connector strand(s) may be higher than in a design that relies on pure out of plane bending such as in Figure 9, which may reduce the likelihood of connector failure in use.

To ease manufacture, it may be advantageous to have the connector strands formed in a substantially planar fashion in a plane parallel to the substrate(s).

Figure 9 shows a cross-sectional view of another example of a thermoelectric module 700. The view is an equivalent view to that of Figure 3. As compared with the thermoelectric module 100, like reference numerals are utilised to indicate equivalent features of the thermoelectric module 700, except that the reference numerals start with a "7" instead of a "1".

The thermoelectric module 700 is substantially the same as the thermoelectric module 100, except that the first connector strand 701a and the second connector strand 701b have a different configuration.

The first connector strand 701a and the second connector strand 701b each have a generally sinusoidal form and are arranged in parallel with each other. The first connector strand 701a and the second connector strand 701b may be considered an example of a pair of nested or layered connector strands.

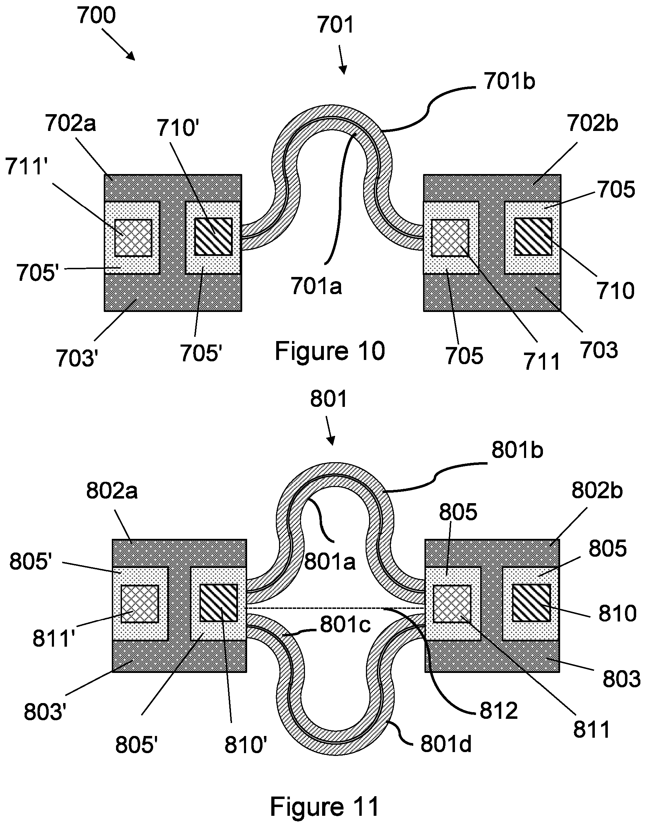

Figure 11 shows a cross-sectional view of another example of a thermoelectric module 800. The view is an equivalent view to that of Figure 3. As compared with the thermoelectric module 100, like reference numerals are utilised to indicate equivalent features of the thermoelectric module 800, except that the reference numerals start with an "8" instead of a "1".

The thermoelectric module 800 is substantially the same as the thermoelectric module 100, except that connector 801 has a different configuration. The connector 801 includes the first connector strand 801a and the second connector strand 801b, which each have a generally sinusoidal form and are arranged in parallel with each other. The first connector strand 801a and the second connector strand 801b constitute a first pair of nested connector strands.

The connector 801 also includes a third connector strand 801c and a fourth connector strand 801d. The third connector strand 801c and the fourth connector strand 801d each have a generally sinusoidal form and are arranged in parallel with each other. The third connector strand 801c and the fourth connector strand 801d constitute a second pair of nested connector strands.

The first pair of nested connector strands and the second pair of nested connector strands have a mirroring geometry either side of a plane of reflection indicated by a dashed line 812.

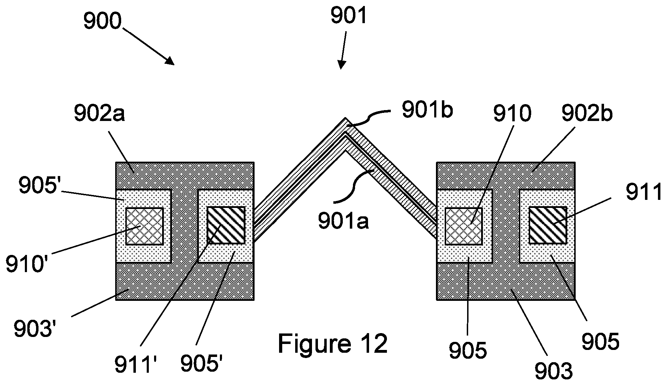

Figure 12 shows a cross-sectional view of another example of a thermoelectric module 900. The view is an equivalent view to that of Figure 3. As compared with the thermoelectric module 100, like reference numerals are utilised to indicate equivalent features of the thermoelectric module 900, except that the reference numerals start with a "9" instead of a "1".

The thermoelectric module 900 is substantially the same as the thermoelectric module 100, except that the first connector strand 901a and the second connector strand 901b have a different configuration.

Each of the first connector strand 901a and the second connector strand 901b have a ridged geometry including a square corner at a midpoint thereof. The first connector strand 901a and the second connector strand 901b are arranged in parallel with each other. The first connector strand 901a and the second connector strand 901b may be considered another example of a pair of nested or layered connector strands.

In order to minimise the space required to fit multiple connector strands between the two given sub-modules, it can be advantageous to layer, or nest the connector strands of the connector, e.g. as shown in Figures 10-12. As such, one or more of the connectors may include an inner connector strand and an outer connector strand, wherein the inner connector strand is nested within the outer connector strand. Increasing the number of connector strands may increase redundancy, and/or may decrease the electrical resistance of the connector, reducing the performance loss from the connector. Multiple connector strands may be more advantageous than a single connector strand of the same width or cross-sectional area as the sum of the widths or cross-sectional areas of the multiple connector strands, as although they may have the same electrical resistance, multiple connector strands may have an increased flexibility and/or higher force at failure over a single connector strand.

In the thermoelectric element 700 of Figure 10, the first connector strand 701a and the second connector strand 701b adopt an arced meander geometry. The first strand 701a and the second strand 701b are nested together to provide the pair of nested connector strands such that the first connector strand 701a forms an inner arc and the second connector strand 301b forms an outer arc.

In the thermoelectric module 800 of Figure 11, the first connector strand 801a and the second connector strand 801b adopt an arced geometry, in which the first connector strand 801a and the second connector strand 801b are nested together to provide the first pair of nested connector strands such that the first connector strand 801a forms an inner arc and the second connector strand 801b forms an outer arc.

The third connector strand 801c and the fourth connector strand 801d are nested together to provide the second pair of nested connector strands such that the third connector strand 801c forms an inner arc and the fourth connector strand 801d forms an outer arc.

A mirroring geometry such as the arrangement of the connector 801 in the thermoelectric module 800 can be advantageous, as this may result in a more stable stretching of the connector 800 as any twisting or out of plane distortion by one of the pairs of nested connector strands may be balanced by the mirroring one of the pairs of nested connector strands acting in an opposite direction.

In the thermoelectric module 900 of Figure 12, the first connector strand 901a and the second connector strand 901b are nested together to provide a pair of nested connector strands, in which the first connector strand 901a may be considered to form an inner ridged layer and the second connector strand 901b may be considered to form an outer ridged layer.

Such nesting or layering of connector strands may require some changes in the shape of each connector strand, for example increasing the radius of some portions of an arc in an outer connector strand and decreasing the radius of other portions of an arc in an inner connector strand so that the inner connector strand can nest inside the outer connector strand. Provided that these radius changes are not very large changes (e.g. the ratio of the radii from the outer connector strand to the inner connector strand lie within the range 0.5 to 2) this can be accommodated with only a small difference in electrical and mechanical performance.

Two or more connector strands may be used in a connector between adjacent sub-modules. An even number of strands may be used in a connector between sub-modules. An odd number of strands may be used in a connector between sub-modules. For example, three or four strands may be used in a connector between sub-modules.

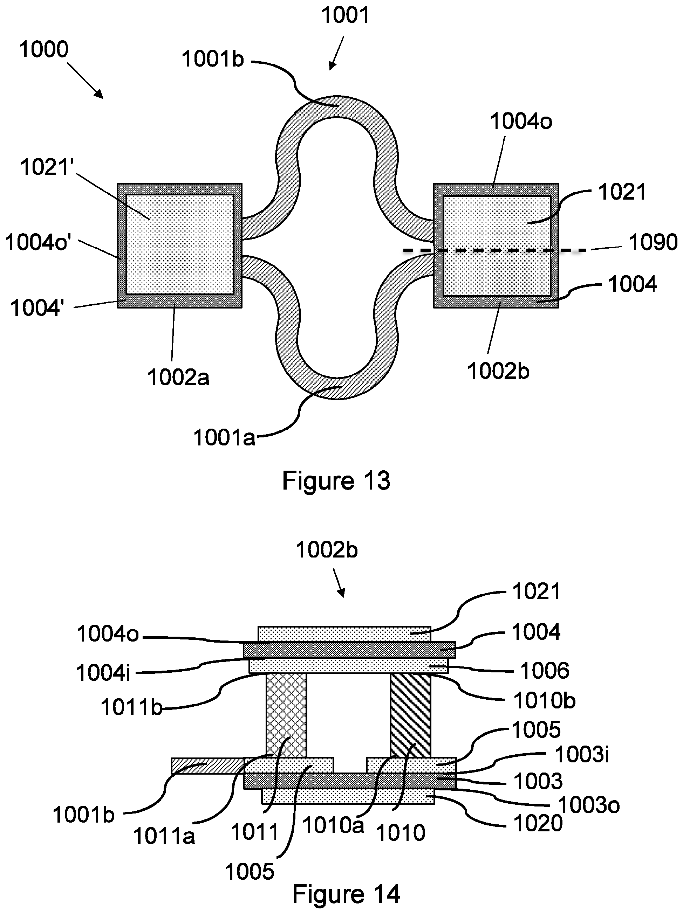

Another example of a thermoelectric module 1001 is shown in Figure 13. The thermoelectric module 1001 includes a first sub-module 1002a and a second sub-module 1002b. Figure 14 is a cross-sectional view of the second sub-module 1002b viewed from a plane indicated by a dashed line 1090 in Figure 13.

Figure 13 is an equivalent view to that of Figure 1 and Figure 14 is an equivalent view to that of Figure 2. As compared with the thermoelectric module 100, like reference numerals are utilised to indicate equivalent features of the thermoelectric module 1000, except that the reference numerals start with a "10" instead of a "1".

The thermoelectric module 1000 is substantially the same as the thermoelectric module 100, except that there are outer layers disposed outer faces of the substrates.

In the first sub-module 1002a, a first outer layer is disposed on an outer face of the first substrate 1003' and a second outer layer 1021' is disposed on an outer face 1004o' of the second substrate 1004'.

In the second sub-module 1002b, a first outer layer 1020 is disposed on an outer face 1003o of the first substrate 1003 and a second outer layer 1021 is disposed on an outer face 1004o of the second substrate 1004.

By being disposed on the opposite faces of the substrates to the electrical interconnects, one or more of the outer layers may add stiffness to a given sub-module, helping to protect the thermoelectric elements by distributing any applied stresses more evenly across the sub-module and/or making assembly easier. This may be especially advantageous when using flexible substrates. One or more of the outer layers may have a relatively high thermal conductivity (e.g. >10 W/m/K), as this may improve thermal performance by improving the lateral thermal spreading from the thermoelectric elements, reducing any temperature drops across thermal interfaces to thermal systems interfacing with the thermoelectric module.

In a given sub-module, an outer layer may be disposed on an outer face of the first substrate and/or an outer layer may be disposed on an outer face of the second substrate. One or more of the outer layers may be continuous or discontinuous across at least a portion of the outer face of the substrate on which the outer layer is disposed. One or more of the outer layers may include a pattern at least partially to the arrangement of electrical interconnects on the opposite face of the substrate.

Suitable metals for the additional outer layers may include metals, and may include but are not limited to copper, silver, gold, nickel, aluminium, platinum, tin, lead or combinations or multiple layers of the above. For simplicity in manufacture, the material of one or more of the outer layer may be the same as the material for one or more of the electrical interconnects. For simplicity in manufacture, the thickness of one or more of the outer layers may be the same as the thickness for the one or more electrical interconnects.

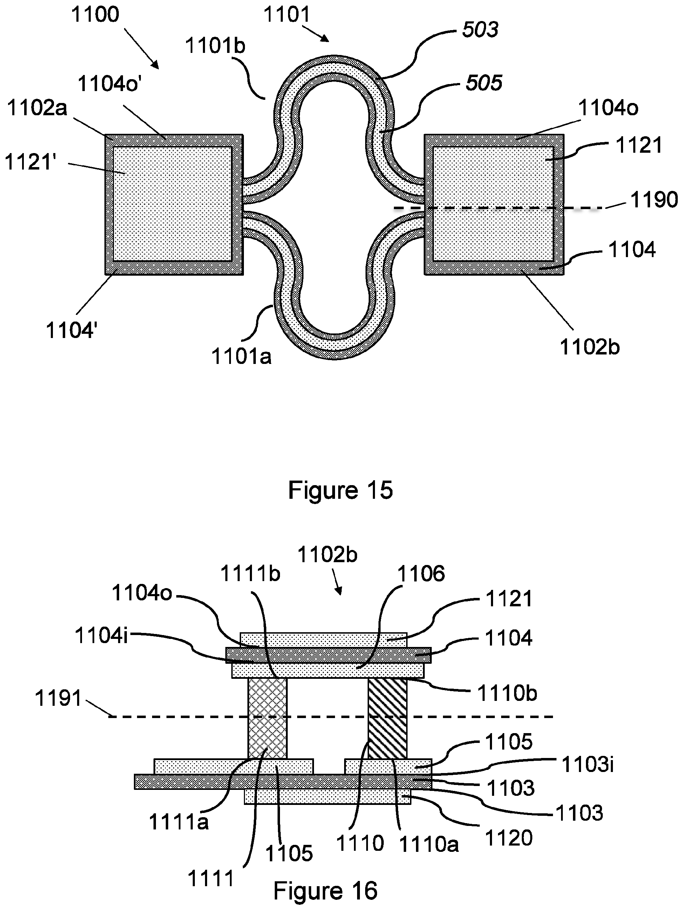

An example of a thermoelectric module 1100 is shown in Figures 15 to 18.

A plan view of the thermoelectric module 1100 is shown in Figure 15. The thermoelectric module 1100 includes a first sub-module 1102a and a second sub-module 1102b.

Figure 16 is a cross-sectional view of the second sub-module 1102b viewed from a first plane indicated by the first dashed line 1190 in Figure 15.

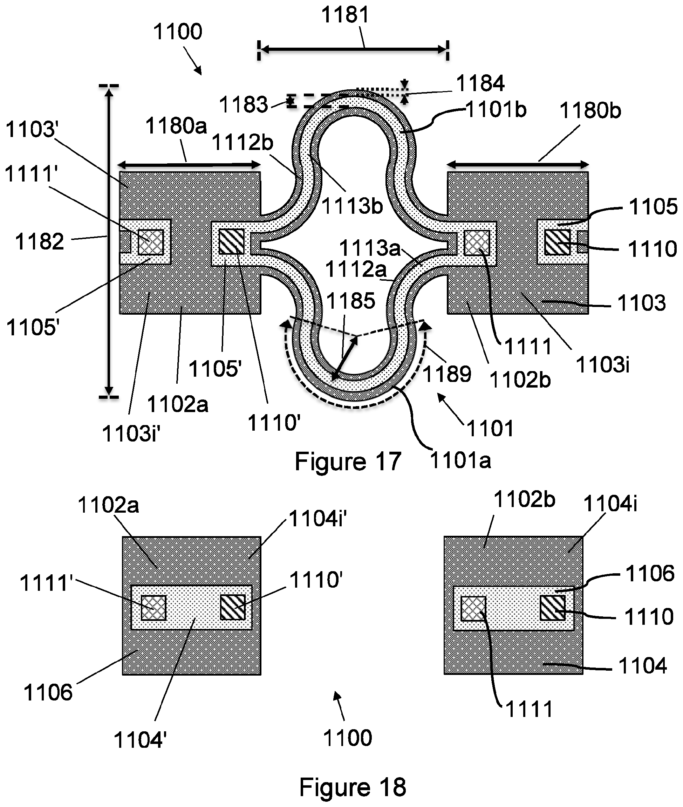

Figure 17 is a cross-sectional view of the thermoelectric module 1100 viewed in a direction towards a first substrate 1103' of the first sub-module 1102a and a first substrate 1103 of the second sub-module 1102b from a second plane indicated by the second dashed line 1191 in Figure 16.

Figure 18 is a cross-sectional view of the thermoelectric module 1100 viewed in a direction towards a second substrate 1104' of the first sub-module 1102a and a second substrate 1104 of the second sub-module 1102b from the second plane indicated by the second dashed line 1191 in Figure 16.

As compared with the thermoelectric module 1000, like reference numerals are utilised to indicate equivalent features of the thermoelectric module 1100, except that the reference numerals start with an "11" instead of a "10".

The thermoelectric module 1100 is substantially the same as the thermoelectric module 1000, except that the connector 1101 is formed differently.

In the thermoelectric module 1100, the first connector strand 1101a includes a first connector strand substrate 1112a and a first connector strand electrical interconnect 1113b disposed thereon.

The first connector strand substrate 1112a extends from the first substrate 1103' of the first sub-module 1102a to the first substrate 1103 of the second sub-module 1102b. The first connector strand substrate 1112a and the first substrate 1103' of the first sub-module 1102a and/or the first substrate 1103 of the second sub-module 1102b may be formed of a continuous piece of material. The first connector strand substrate 1112a and the first substrate 1103' of the first sub-module 1102a and/or the first substrate 1103 of the second sub-module 1102b may be considered extensions of each other.

The first connector strand electrical interconnect 1113a extends from the second one of the first electrical interconnects 1105' of the first sub-module 1102a to the first one of the first electrical interconnects 1105 of the second sub-module 1102b. The first connector strand electrical interconnect 1113a and the second one of the first electrical interconnects 1105' of the first sub-module 1102a and/or the first one of the first electrical interconnects 1105 of the second sub-module 1102b may be formed of a continuous piece of material. The first connector strand electrical interconnect 1113a and the second one of the first electrical interconnects 1105' of the first sub-module 1102a and/or the first one of the first electrical interconnects 1105 of the second sub-module 1102b may be considered extensions of each other.

The second connector strand 1101b includes a second connector strand substrate 1112b and a second connector strand electrical interconnect 1113b disposed thereon.

The second connector strand substrate 1112b extends from the first substrate 1103' of the first sub-module 1102a to the first substrate 1103 of the second sub-module 1102b. The second connector strand substrate 1112b and the first substrate 1103' of the first sub-module 1102a and/or the first substrate 1103 of the second sub-module 1102b may be formed of a continuous piece of material. The second connector strand substrate 1112b and the first substrate 1103' of the first sub-module 1102a and/or the first substrate 1103 of the second sub-module 1102b may be considered extensions of each other.

The second connector strand electrical interconnect 1113b extends from the second one of the first electrical interconnects 1105' of the first sub-module 1102a to the first one of the first electrical interconnects 1105 of the second sub-module 1102b. The second connector strand electrical interconnect 1113b and the second one of the first electrical interconnects 1105' of the first sub-module 1102a and/or the first one of the first electrical interconnects 1105 of the second sub-module 1102b may be formed of a continuous piece of material. The second connector strand electrical interconnect 1113b and the second one of the first electrical interconnects 1105' of the first sub-module 1102a and/or the first one of the first electrical interconnects 1105 of the second sub-module 1102b may be considered extensions of each other.

The other first electrical interconnects 1105', 1105 are each configured to be connected to a pair of connector strand electrical interconnects.

Extending one or more of the first substrates 1103', 1103 to form one or more of the connector strand substrates 1112a, 1112b and/or extending one or more of the first electrical interconnects 1105', 1105 to form one or more of the connector strand electrical interconnects 1113a, 1113b may help to simplify manufacturing of the thermoelectric module, as one or more of the connectors and first substrates may be formed in one step. No additional assembly operation may be required to bond them together that may also affect their flexibility.

Some of the dimensions that may be associated with an implementation of a thermoelectric module according to the disclosure will now be discussed with reference to the thermoelectric module 1100 and Figure 17. It will be appreciated, however, that the thermoelectric module 1100 merely constitutes an example of a thermoelectric module 1100 according to the present disclosure. One or more of the example dimensions discussed below may be applied to any one of the examples disclosed herein. Equally, implementations of a thermoelectric module according to this disclosure may have dimensions other than the specific examples disclosed herein.

The first substrate 1103' of the first sub-module 1102a is square in shape and has a side length indicated by a first double-headed arrow 1180a. The side length may be 1 mm or more and/or up to 50 mm. The side length may be 2 mm or more or 3 mm or more. The side length may be up to 40 mm, up to 30 mm, up to 25 mm, up to 20 mm or up to 15 mm.

The first substrate 1103 of the second sub-module 1102b is square in shape as has a side length indicated by a second double-headed arrow 1180b. The side length may be 1 mm or more and/or up to 50 mm. The side length may be 2 mm or more or 3 mm or more. The side length may be up to 40 mm, up to 30 mm, up to 25 mm, up to 20 mm or up to 15 mm.

In implementations, the second substrate of a given sub-module may have substantially the same dimensions (e.g. side length) as the first substrate of the given sub-module.

The connector 1101 has a length indicated by a third double-headed arrow 1181. The length of the connector 1101 may be 1 mm or more and/or up to 50 mm. The length of the connector 1101 may be 2 mm or more or 3 mm or more. The length of the connector 1101 may be up to 40 mm, up to 30 mm, up to 25 mm, up to 20 mm or up to 15 mm.

The length of the connector 1101 may correspond to a spacing between the first substrate 1103' of the first sub-module 1102a and the first substrate 1103 of the second sub-module 1102b when the first connector strand 1101a and the second connector strand 1101b are in a neutral (i.e. unstressed) arrangement. The length of the connector 1101 may be varied, in use, by bending, compressing and/or stretching the first connector strand 1101a and the second connector strand 1101b.

The first connector strand 1101a and the second connector strand 1101b have a mirroring geometry and are otherwise substantially identical to each other.

A width 1183 of the first connector strand electrical interconnect 1113a and a width of the second connector strand electrical interconnect 1113b may be 0.025 mm or more, 0.05 mm or more or 0.1 mm or more. The width 1183 may be up to 5 mm, up to 4 mm, up to 3 mm, up to 2 mm or up to 1 mm.

A spacing 1184 between the edges of the connector strand electrical interconnects and the edges of the connector strand substrates may be 0.025 mm or more, 0.05 mm or more or 0.1 mm or more. The spacing 1184 may be up to 1 mm, up to 0.9 mm, up to 0.8 mm, up to 0.7 mm or up to 0.6 mm.

A balance in the size of the radius of the or an arc in a connector strand may be important, as too small a radius may reduce the extension of the connector strand before failure, and/or can reduce the failure force, but too high a radius may take up too much space, reducing the area available for the sub-modules with the thermoelectric elements. In implementations, the connector and/or one or more of the connector strands may include circular arcs, to reduce any local stress concentrations, which may increase the elongation and maximum force at failure.

With reference to Figure 17, a centreline radius 1185 of one or more of the arcs may be at least 0.1 mm and/or up to 10 mm. For instance, the centreline radius 1185 may be in the range of from 0.5 mm to 5 mm.

In implementations, one or more of the connector strands may include three arc sections along the length of the connector strand. An angular extent 1189 of a middle one of the arc sections may be in the range of from 150° to 270°. The angular extent 1189 may be in the range of from 170° to 230°.

In implementations, one or more of the substrates may have a thickness of 0.005 mm or greater, such as 0.01 mm or greater.

One or more of the substrates may have a thickness of 1 mm or less, such as 0.5 mm or less, 0.1 mm or less, or 0.06 mm or less.

In implementations, one or more of the substrates may have a thickness in the range of from 0.005 mm to 1 mm, such as from 0.005 mm to 0.5 mm, from 0.01 mm to 0.5 mm, from 0.01 mm to 0.1 mm, or from 0.01 mm to 0.06 mm. Such a thickness of the substrate may help to balance flexibility, robustness and the ability to assemble the sub-module, the thermoelectric module and/or a thermoelectric device including one or more thermoelectric modules.

In implementations, one or more of the electrical interconnects may have a thickness of 0.005 mm or greater, such as 0.01 mm or greater.

In implementations, one or more of the electrical interconnects may have a thickness of 0.5 mm or less, such as 0.3 mm or less, 0.1 mm or less, or 0.08 mm or less.

For instance, one or more of the electrical interconnects may have a thickness in the range of from 0.005 mm to 0.5 mm, such as from 0.005 mm to 0.3 mm, from 0.005 mm to 0.1 mm, from 0.01 mm to 0.1 mm, or from 0.01 mm to 0.08 mm. This may help to balance electrical resistance with flexibility. In implementations, a thickness of one or more of the outer layers, if present, may be similar to the thickness of the electrical interconnect(s) to ease manufacture.

In implementations, one or more of the sub-modules may include more than two thermoelectric elements.

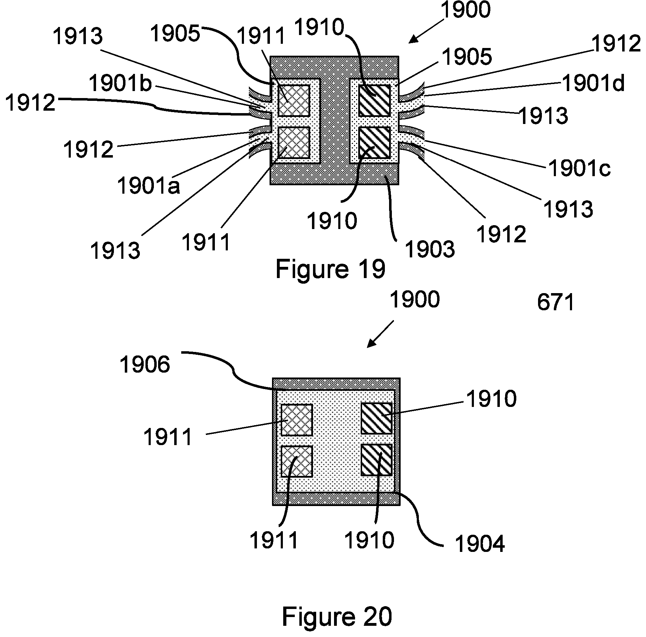

Referring to Figures 19 and 20, an example of a sub-module 1900 for a thermoelectric module includes a first substrate 1903 and a second substrate 1904. Figure 19 is a cross-sectional view of the sub-module 1900 looking towards the first substrate 1903. Figure 20 is a cross-sectional view of the sub-module 1900 looking towards the second substrate 1904.

The first substrate 1903 has two first electrical interconnects 1905 disposed thereon. Each one of the first electrical interconnects 1905 is rectangular in shape. The first electrical interconnects 1905 are spaced apart from each other. Each one of a first pair of connector strands 1901a, 1901b includes a connector strand substrate 1912 extending from the first substrate 1903 and a connector strand electrical interconnect 1913 disposed on the connector strand substrate 1912 and extending from a first one of the first electrical interconnects 1905. Each one of a second pair of connector strands 1901c, 1901d includes a connector strand substrate 1912 extending from the first substrate 1903 and a connector strand electrical interconnect 1913 disposed on the connector strand substrate 1912 and extending from a second one of the first electrical interconnects 1905.

The second substrate 1904 has a second electrical interconnect 1906 disposed thereon. The second electrical interconnect 1906 extends across a major portion of an inner surface of the second substrate 1904.

A pair of first thermoelectric elements 1911 are disposed in parallel between the first substrate 1903 and the second substrate 1904. A first end of each one of the pair of first thermoelectric elements 1911 is electrically connected to the first one of the first electrical interconnects 1905. A second end of each one of the pair of first thermoelectric elements 1912 is electrically connected to the second electrical interconnect 1906.

A pair of second thermoelectric elements 1910 are disposed in parallel between the first substrate 1903 and the second substrate 1904. A first end of each one of the pair of second thermoelectric elements 1910 is electrically connected to the second one of the first electrical interconnects 1905. A second end of each one of the pair of second thermoelectric elements 1910 is electrically connected to the second electrical interconnect 1906.

The first thermoelectric elements 1911 may be n-type thermoelectric elements and the second thermoelectric elements 1910 may be p-type thermoelectric elements of vice versa.

In the sub-module 1900, the thermoelectric elements of one type (n-type or p-type) are electrically connected in parallel with each other and in series with the thermoelectric elements of the opposite type.

Each thermoelectric element is electrically connected in parallel to another thermoelectric element of the same type, and in series to the thermoelectric elements of opposite type. Such parallel electrical connection gives further redundancy in the thermoelectric module, so failure at any one point may not result in complete failure of the thermoelectric module in operation. However, the parallel electrical connection results in a higher current, lower voltage operation, so losses from the resistance of the electrical interconnects and the connector may be larger.

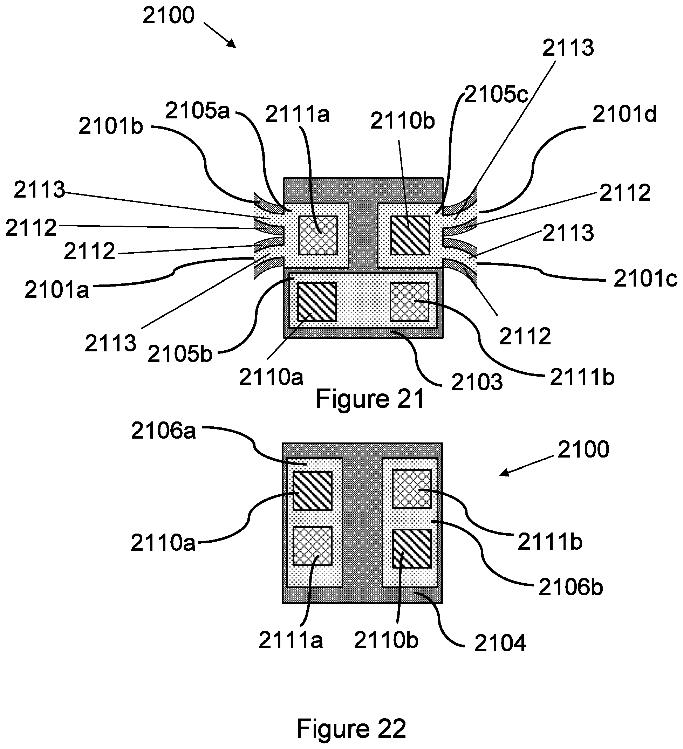

Referring to Figures 21 and 22, another example of a sub-module 2100 for a thermoelectric module includes a first substrate 2103 and a second substrate 2104. Figure 21 is a cross-sectional view of the sub-module 2100 looking towards the first substrate 2103. Figure 22 is a cross-sectional view of the sub-module 2100 looking towards the second substrate 2104.

The first substrate 2103 has three first electrical interconnects 2105a, 2105b, 2105c disposed thereon. A first one of the first electrical interconnects 2105a is square in shape. A second one of the first electrical interconnects 2105b is rectangular in shape. A third one of the first electrical interconnects 2105c is square in shape. The first electrical interconnects 2105a, 2105b, 2105c are spaced apart from each other.

Each one of a first pair of connector strands 2101a, 2101b includes a connector strand substrate 2112 extending from the first substrate 2103 and a connector strand electrical interconnect 2113 disposed on the connector strand substrate 2112 and extending from the first one of the first electrical interconnects 2105a. Each one of a second pair of connector strands 2101c, 2101d includes a connector strand substrate 2112 extending from the first substrate 2103 and a connector strand electrical interconnect 2113 disposed on the connector strand substrate 2112 and extending from the third one of the first electrical interconnects 2105c.

The second substrate 2104 has two second electrical interconnects 2106a, 2106b disposed thereon. A first one of the second electrical interconnects 2106a is rectangular in shape. A second one of the second electrical interconnects 2106b is rectangular in shape. The second electrical interconnects 2106a, 2106b are spaced apart from each other.

Two first thermoelectric elements 2111a, 2111b are disposed between the first substrate 2103 and the second substrate 2104. A first end of a first one of the first thermoelectric elements 2111a is electrically connected to the first one of the first electrical interconnects 2105. A second end of the first one of the first thermoelectric elements 2111a is electrically connected to the first one of the second electrical interconnects 2106a. A first end of a second one of the first thermoelectric elements 2111b is electrically connected to the second one of the first electrical interconnects 2105b.

Two second thermoelectric elements 2110a, 2110b are disposed between the first substrate 2103 and the second substrate 2104. A first end of a first one of the second thermoelectric elements 2110a is electrically connected to the second one of the first electrical interconnects 2105b. A second end of the first one of the second thermoelectric elements 2110a is electrically connected to the first one of the second electrical interconnects 2106a. A first end of a second one of the second thermoelectric elements 2110b is electrically connected to the third one of the first electrical interconnects 2105c. A second end of the second one of the second thermoelectric elements 2110b is electrically connected to the second one of the first electrical interconnects 2105b.

The first thermoelectric elements 2111a, 2111b may be n-type thermoelectric elements and the second thermoelectric elements 2110a, 2110b may be p-type thermoelectric elements of vice versa.

The sub-module 2100 includes a series of four thermoelectric elements of alternating types connected in electrical series. In order from the first pair of connector strands 2101a, 2101b to the second pair of connector strands 2101c, 2101d, the series of thermoelectric elements includes the first one of the first thermoelectric elements 2111a, the first one of the second thermoelectric elements 2110a, the second one of the first thermoelectric elements 2111b and the second one of the second thermoelectric elements 2110b.

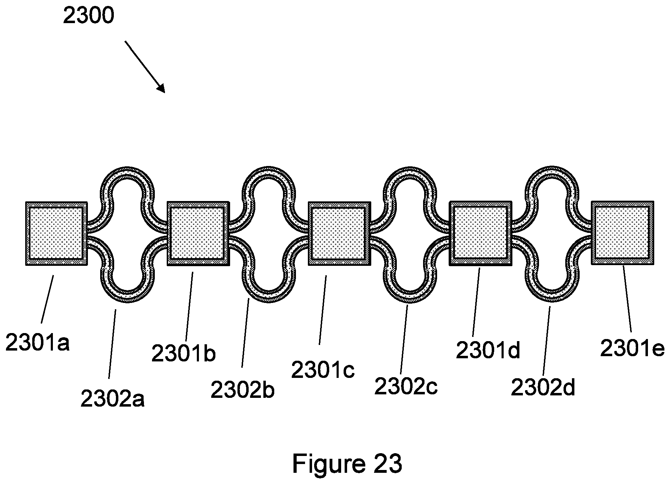

Figure 23 shows a plan view of an example of a thermoelectric module 2300 including a string of more than two sub-modules and connectors, demonstrating its modularity and scalability to any number of sub-modules. In the illustrated example, the thermoelectric module 2300 includes five sub-modules 2301a, 2301b, 2301c, 2301d, 2301e connected in electrical series. One or more, e.g. all, of the sub-modules 2301a, 2301b, 2301c, 2301d, 2301e may be any sub-module according to the present disclosure. The sub-modules 2301a, 2301b, 2301c, 2301d, 2301e are connected to each other by four connectors 2302a, 2302b, 2302c, 2302d. One or more, e.g. all, of the connectors 2302a, 2302b, 2302c, 2302d may include one or more flexible and/or stretchable connectors according to the present disclosure. Electrical wires (not shown) or similar electrical contact to the thermoelectric module 2300 may be made at one end of the string or both ends of the string.

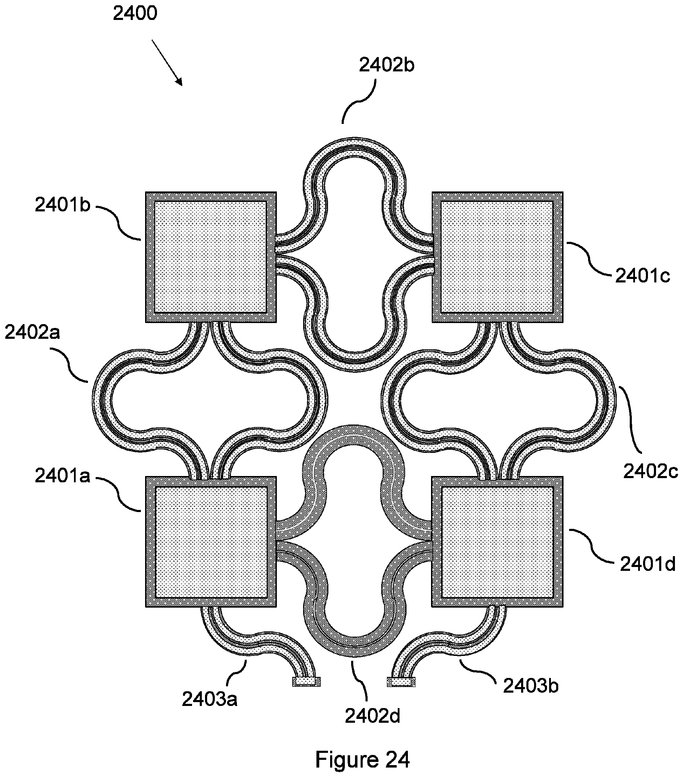

Figure 24 is a plan view of another thermoelectric module 2400. The thermoelectric module 2400 includes four sub-modules 2401a, 2401b, 2401c, 2401d arranged in a two-dimensional array including a 2x2 arrangement with four connectors 2402a, 2402b, 2402c, 2402d connecting neighbouring sub-modules 2401a, 2401b, 2401c, 2401d to each other. Each sub-module 2401a, 2401b, 2401c, 2401d is connected to two other sub-modules.

The four sub-modules 2401a, 2401b, 2401c, 2401d are electrically connected in series. A first one of the connectors 2402a electrically connects a first one of the sub-modules 2401a to a second one of the sub-modules 2401b. A second one of the connectors 2402b electrically connects the second one of the sub-modules 2401b to a third one of the sub-modules 2401c. A third one of the connectors 2402c electrically connects the third one of the sub-modules 2401c to a fourth one of the sub-modules 2401d.

A fourth one of the connectors 2402d connects the first one of the sub-modules 2401a to the fourth one of the sub-modules 2401d, but is electrically inactive, i.e. the fourth one of the connectors 2402d does not provide an electrical connection between the first one of the sub-modules 2401a and the fourth one of the sub-modules 2401d.

One or more, e.g. all, of the sub-modules 2401a, 2401b, 2401c, 2401d may be any sub-module according to the present disclosure.

One or more, e.g. all, of the connectors 2402a, 2402b, 2402c, 2402d may include one or more flexible and/or stretchable connectors according to the present disclosure.

A first electrical connector 2403a and a second electrical connector 2403b are configured to provide an external electrical connection at a first end and a second end of the string respectively. Use of a first electrical connector 2403a and a second electrical connector 2403b may reduce any local stresses from the external electrical connections.

The thermoelectric module 2400 includes an example of an array of sub-modules and such an array may allow flexibility and/or stretchability for complex surfaces, e.g. including curves or bends in two different directions. It will be appreciated that the sub-modules and connectors of the present disclosure are modular, so can be scaled to arbitrary larger numbers and arrangements, e.g. arrays, of sub-modules e.g. arrays including 4 by 4 sub-modules or 2 by 4 sub-modules.

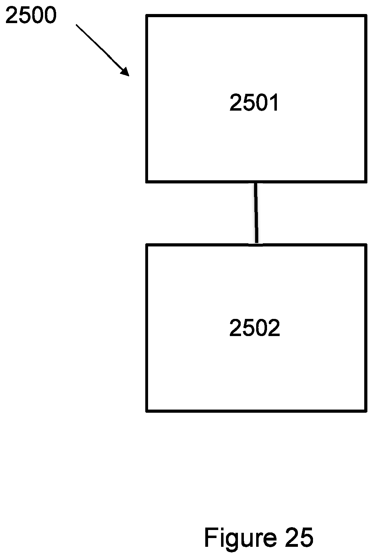

Figure 25 is a schematic diagram 2500 of a method of manufacturing a thermoelectric module. Step 2501 includes providing a first sub-module and a second sub-module; and step 2502 includes coupling a connector to the first sub-module and the second sub-module such that the connector extends between the first sub-module and the second sub-module, wherein the connector is flexible and/or stretchable at least in part to allow the relative positions of the first sub-module and the second sub-module to be varied, in use.

For a more uniform distortion when the thermoelectric module or a thermoelectric device comprising the thermoelectric module is deformed, it can be advantageous to include one or more electrically inactive connectors or connector strands between sub-modules, i.e. one or more connectors or connector strands which do not electrically connect thermoelectric elements between sub-modules, i.e. do not carry current when the thermoelectric module is powered.

The connector(s) and/or connector strand(s) may be made electrically inactive, for example, by including a connector substrate or connector strand substrate, but not including a connector electrical interconnect on the connector substrate or a connector strand electrical interconnect on the connector strand substrate, respectively. If the connector electrical interconnect or connector strand electrical interconnect is absent, the mechanical properties of the electrically inactive connector or the electrically inactive connector strand may be different from the otherwise identical electrically active connector(s) or electrically active connector strand(s).

For more uniform distortion of the thermoelectric module or a thermoelectric device including the thermoelectric module when deformed it may be beneficial if the electrically inactive connector(s) have similar mechanical properties to the electrically active connector(s). This may be achieved, for example, by applying the or a first outer layer to the connector portion of the first substrate, where it can provide substantially similar mechanical performance, but is not electrically connected to the thermoelectric elements, so is electrically inactive, not carrying current when the device is powered.

In implementations, to avoid electrical shorting between the different connectors or between the connectors and any conductive parts of any wider system, the electrical interconnect layers may be at least partially covered with an insulating layer. This insulating layer may comprise the same material as the substrate. This insulating layer may comprise a solder mask.

The connectors have been illustrated with examples with the connectors joining or forming part of the first substrate. In another embodiment of the invention, the connectors may join or form part of both the first and second substrates. Connectors between neighbouring sub-modules using both the first and second substrate may give further resilience to failure due to the additional connectors. The connector between only one of the substrates may be electrically active. The connector may alternate between substrates along the string or around the array of sub-modules. This allows for an odd number of thermoelectric elements in series within the sub-module.

In implementations, one or more of the sub-modules may have a longest lateral dimension, e.g. a width, of 1 mm or greater, such as 2 mm or greater, or 3 mm or greater.

One or more of the sub-modules may have a longest lateral dimension, e.g. a width, of 40 mm or less, such as 30 mm or less, 20 mm or less, or 15 mm or less.

In implementations, one or more of the sub-modules may have a longest lateral dimension, e.g. a width, in the range of from 1 mm to 40 mm, such as from 1 mm to 30 mm, from 1 mm to 25 mm, from 2 mm to 20 mm, or from 3 mm to 15 mm.

In implementations, one or more of the connectors may have a length of 1 mm or greater, such as 2 mm or greater, or 3 mm or greater.

One or more of the connectors may have a length of 40 mm or less, such as 30 mm or less, 20 mm or less, or 15 mm or less.

One or more of the connectors may have a in the range of from 1 mm to 40 mm, such as from 1 mm to 30 mm, from 1 mm to 25 mm, from 2 mm to 20 mm, or from 3 mm to 15 mm.

A width of the or an electrical interconnect in a given connector may be 0.025 mm or greater, such as 0.05 mm or greater, or 0.1 mm or greater.

A width of the or an electrical interconnect in a given connector may be 5 mm or less, such as 4 mm or less, 2 mm or less, or 1 mm or less.

A width of the or an electrical interconnect in a given connector may be in the range of from 0.025 mm to 5 mm, such as from 0.025 mm to 4 mm, from 0.05 mm to 3 mm, from 0.05 mm to 2 mm, or from 0.1 mm to 1 mm.

A spacing between the or an electrical interconnect in a given connector or connector strand and an edge of the given connector or connector strand may be 0.025 mm or greater, such as 0.05 mm or greater, or 0.1 mm or greater.

A spacing between the or an electrical interconnect in a given connector or connector strand and an edge of the connector or connector strand may be 1 mm or less, such as 0.9 mm or less, 0.8 mm or less, 0.7 mm or less, or 0.6 mm or less.

A spacing between the or an electrical interconnect in a given connector or connector strand and an edge of the given connector or connector strand may lie in the range of from 0.025 mm to 1 mm, such as from 0.025 mm to 0.9 mm, from 0.025 mm to 0.8 mm, from 0.05 mm to 0.7 mm, or from 0.1 mm to 0.6 mm.

Suitable metals for the electrical interconnects may include but are not limited to copper, silver, gold, nickel, aluminium, platinum, tin, lead, carbon or combinations or multiple layers of the above.

Suitable thermoelectric materials for the thermoelectric elements may include, but are not limited to: bismuth telluride; bismuth selenide; antimony telluride; lead telluride; lead selenide; magnesium silicide; magnesium stannide; higher manganese silicide; magnesium antimonide; magnesium bismuthide; skutterudite materials; Half Heusler alloys; silicon-germanium, oxides and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

The first substrate and the second substrate in a given sub-module may be made of a suitable material that is an electrical insulator. One or more of the substrates may be rigid. One or more of the substrates may comprise, for example, aluminium oxide, aluminium nitride, silicon nitride or beryllium oxide.

In implementations, one or more of the first substrate and/or the second substrate may comprise or be made at least partially of a flexible material. The flexible material may have a relatively low Young's modulus, e.g. a Young's modulus of up to 20 GPa. Consequently, stress concentrations may be reduced or avoided and/or the sub-module and/or the thermoelectric module may be more flexible. Suitable materials for the first substrate and/or the second substrate may include but are not limited to polyimide, polyethylene terephthalate (PET), polyetheretherketone (PEEK), poly methyl methacrylate (PMMA), polystyrene, cyclic olefin copolymer (COC).

Suitable materials for the first electrical interconnects and/or the second electrical interconnects may include but are not limited to metals such as copper, silver, gold, nickel, aluminium, platinum, tin, lead or combinations or multiple layers of the above. It will be understood that the invention is not limited to the examples described above. Various modifications and improvements can be made without departing from the concepts disclosed herein. Except where mutually exclusive, any of the features may be employed separately or in combination with any other features and the disclosure extends to all combinations and sub-combinations of any one or more features disclosed herein.

## Claims

1. A thermoelectric module comprising:
- a first sub-module and a second sub-module, wherein the first sub-module and the second sub-module each include:
o a first substrate with one or more first electrical interconnects provided thereon;
o a second substrate with one or more second electrical interconnects provided thereon; and
o two or more thermoelectric elements disposed between the first substrate and the second substrate,
wherein a first end of each thermoelectric element is electrically connected to one of the first electrical interconnects and a second end of each thermoelectric element is electrically connected to one of the second electrical interconnects, wherein at least two of the thermoelectric elements are electrically connected in series to form at least one thermocouple; and
- a connector coupled to and extending between the first sub-module and the second sub-module, wherein the connector is flexible and/or stretchable at least in part to allow the relative positions of the first sub-module and the second sub-module to be varied, in use.

2. The thermoelectric module of claim 1, wherein one or more of the connectors comprises a plurality of connector strands, optionally wherein each connector strand is independently coupled to and extends between a first one of the sub-modules and a second one of the sub-modules.

3. The thermoelectric module of claim 1 or claim 2, wherein one or more of the connectors or a part thereof is/are deformable from a neutral position or arrangement and/or wherein one or more of the connectors or a part thereof is/are resiliently biased to the or a neutral position.

4. The thermoelectric module of claim 2, or claim 3 when dependent on claim 2, wherein two or more of the connector strands adopt a mirroring geometry.

5. The thermoelectric module of claim 2, or any one of claims 3 to 4 when dependent on claim 2, wherein two or more of the connector strands are nested.

6. The thermoelectric module of claim 2, or any one of claims 3 to 5 when dependent on claim 2, wherein one or more of the connector strands comprise a connector strand substrate and, optionally, a connector strand electrical interconnect.

7. The thermoelectric module of any one of the preceding claims including one or more further sub-modules, wherein each sub-module is connected to at least one other sub-module by one or more connectors.

8. The thermoelectric module of any one of the preceding claims, wherein one or more of the connectors is/are electrically conductive.

9. The thermoelectric module of any one of the preceding claims, wherein one or more of the connectors or a part thereof adopt a non-linear geometry, optionally wherein the non-linear geometry includes a curved geometry, a sinusoidal geometry, a serpentine shape, an arced geometry, a ridge geometry and/or a castellated geometry.

10. The thermoelectric module of any one of the preceding claims, wherein at least one of the following applies:
(a) one or more of the connectors or a part thereof constitute an extension of one of the substrates and/or one of the electrical interconnects of the first sub-module and/or the second sub-module
(b) one or more of the sub-modules comprise at least one outer layer disposed on an outer face of the first substrate and/or at least one outer layer disposed on an outer face of the second substrate;
(c) one or more of the connectors comprise a connector substrate and, optionally, a connector electrical interconnect;
(d) one or more of the first electrical interconnects, one or more of the second electrical interconnects, and/or optionally one or more of the connector electrical interconnects are covered at least partially by an insulating layer; and/or
(e) one or more of the connectors and/or one or more of the connector strands is/are electrically inactive.

11. A sub-unit for a thermoelectric module including:
a sub-module including:
a first substrate with one or more first electrical interconnects provided thereon;
a second substrate with one or more second electrical interconnects provided thereon;
two or more thermoelectric elements disposed between the first substrate and the second substrate, wherein a first end of each thermoelectric elements is electrically connected to one of the first electrical interconnects and a second end of each thermoelectric element is electrically connected to one of the second electrical interconnects, wherein two or more of the thermoelectric elements are electrically connected in series to form at least one thermocouple; and
a connector coupled to and extending from the sub-module to connect the sub-module, in use, to another sub-module, wherein the connector is flexible and/or stretchable at least in part to allow the relative positions of the sub-module and the another sub-module to be varied, in use.

12. A thermoelectric device comprising one or more thermoelectric modules according to any one of claims 1 to 10 and/or one or more sub-units according to claim 11.

13. A method of manufacturing a thermoelectric module comprising:
providing a first sub-module and a second sub-module, wherein the first sub-module and the second sub-module each comprise:
a first substrate with one or more first electrical interconnects provided thereon;
a second substrate with one or more second electrical interconnects provided thereon; and
two or more thermoelectric elements disposed between the first substrate and the second substrate, wherein a first end of each thermoelectric element is electrically connected to one of the first electrical interconnects and a second end of each thermoelectric element is electrically connected to one of the second electrical interconnects, wherein two or more of the thermoelectric elements are electrically connected in series to form at least one thermocouple;
coupling a connector to the first sub-module and the second sub-module such that the connector extends between the first sub-module and the second sub-module, wherein the connector is flexible and/or stretchable at least in part to allow the relative positions of the first sub-module and the second sub-module to be varied, in use.

14. The method of claim 13, wherein at least one of the following applies:
(a) the method comprises a preliminary step of manufacturing or assembling the first sub-module and/or the second sub-module;
(b) the step of coupling a connector to the first sub-module and the second sub-module includes forming a connector between the first sub-module and the second sub-module; and/or
(c) the step of forming the connector comprises extending one of the substrates and/or one of the electrical interconnects of the first sub-module and/or the second sub-module between the first sub-module and the second-sub-module.

15. A method of manufacturing a thermoelectric device comprising:
providing at least one thermoelectric module according to any one of claims 1 to 10 or a thermoelectric module manufactured according to a method of manufacture according to any one of claims 13-14; and
configuring the thermoelectric module(s) for use in the thermoelectric device.
